# EUROPEAN PATENT SPECIFICATION

(11) **EP 3 648 553 B1**
(45) Date of publication and mention of the grant of the patent: **19.05.2021**
(21) Application number: 18823378.7
(22) Date of filing: 26.06.2018
(51) Int. Cl.: H01J 37/32, H01J 37/34, H05H 1/46, C23C 14/34, B01J 19/08

(54) **PLASMA TREATMENT DEVICE**
PLASMABEHANDLUNGSVORRICHTUNG
DISPOSITIF DE TRAITEMENT AU PLASMA

(30) Priority: 27.06.2017 WO PCT/JP2017/023611; 27.06.2017 WO PCT/JP2017/023603; 02.02.2018 JP 2018017549
(43) Date of publication of application: 06.05.2020
(73) Proprietor: Canon Anelva Corporation, Kawasaki-shi Kanagawa 215-8550 (JP)
(72) Inventor: SEKIYA, Kazunari, Kawasaki-shi Kanagawa 215-8550 (JP); TANABE, Masaharu, Kawasaki-shi Kanagawa 215-8550 (JP); INOUE, Tadashi, Kawasaki-shi Kanagawa 215-8550 (JP); SASAMOTO, Hiroshi, Kawasaki-shi Kanagawa 215-8550 (JP); SATO, Tatsunori, Kawasaki-shi Kanagawa 215-8550 (JP); TSUCHIYA, Nobuaki, Kawasaki-shi Kanagawa 215-8550 (JP)
(74) Representative: TBK
(86) International application number: PCT/JP2018/024145
(87) International publication number: WO 2019/004183

(56) References cited:
- EP-A1- 1 748 687
- JP-A- H02 156 080
- JP-A- H02 156 081
- JP-A- 2009 105 030
- JP-A- 2009 302 566
- US-A- 4 887 005
- US-A- 5 989 999
- US-A1- 2013 337 657

## Description

### TECHNICAL FIELD

The present invention relates to a plasma processing apparatus.

### BACKGROUND ART

There is provided a plasma processing apparatus that generates plasma by applying a high frequency between two electrodes and processes a substrate by the plasma. Such plasma processing apparatus can operate as an etching apparatus or a sputtering apparatus by the bias and/or the area ratio of the two electrodes. The plasma processing apparatus configured as a sputtering apparatus includes the first electrode that holds a target and the second electrode that holds a substrate. A high frequency is applied between the first and second electrodes, and plasma is generated between the first and second electrodes (between the target and the substrate). When plasma is generated, a self-bias voltage is generated on the surface of the target. This causes ions to collide against the target, and the particles of a material constituting the target are discharged from the target.

The document JP 2009 - 302 566 A describes a plasma surface treatment apparatus including a balanced/unbalanced converter. This plasma surface treatment apparatus includes a high-frequency power source, a power amplifier, an impedance matching device, a coaxial cable, a vacuum container, a discharge gas mixing box, an ungrounded electrode, a grounded electrode, and a transformer type balanced/unbalanced converter. The discharge gas mixing box, the ungrounded electrode, the grounded electrode, and the transformer type balanced/unbalanced converter are arranged in the vacuum container. The ungrounded electrode is installed in the vacuum container via an insulator support material and the discharge gas mixing box. The grounded electrode supports a substrate. Furthermore, the grounded electrode is electrically connected to the vacuum container. An output from the high-frequency power supply is supplied between the ungrounded electrode and the grounded electrode via the power amplifier, the impedance matching device, the coaxial cable, and the transformer type balanced/unbalanced converter. According to the document JP 2009 - 302 566 A, an in-phase current Ix flowing via the member of the vacuum container connected to the grounded electrode is blocked by the transformer type balanced/unbalanced converter.

In the plasma surface treatment apparatus described in the document JP 2009 - 302 566 A, the grounded electrode and the vacuum container are electrically connected, and thus the vacuum container can function as an anode in addition to the grounded electrode. The self-bias voltage can depend on the state of a portion that can function as a cathode and the state of a portion that can function as an anode. Therefore, if the vacuum container functions as an anode in addition to a substrate holding electrode, the self-bias voltage can change depending on the state of a portion of the vacuum container that functions as an anode. The change in self-bias voltage changes a plasma potential, and the change in plasma potential can influence the processing of the substrate, for example, the characteristic of a film to be formed.

If a film is formed on a substrate using the sputtering apparatus, a film can also be formed on the inner surface of the vacuum container. This may change the state of the portion of the vacuum container that can function as an anode. Therefore, if the sputtering apparatus is continuously used, the self-bias voltage changes depending on the film formed on the inner surface of the vacuum container, and the plasma potential can also change. Consequently, if the sputtering apparatus is used for a long period, it is conventionally difficult to keep the characteristic of the film formed on the substrate constant.

Similarly, if the etching apparatus is used for a long period, the self-bias voltage changes depending on the film formed on the inner surface of the vacuum container, and this may change the plasma potential. Consequently, it is difficult to keep the etching characteristic of the substrate constant.

Further background art showing a plasma processing apparatus, including a balun, a vacuum container and first and second electrodes connected to the balun, is known from the documents US 2013/337657 A1, EP 1 748 687 A1, JP H02 156081 A, US 5 989 999 A and US 4 887 005 A.

### SUMMARY OF INVENTION

The present invention has been made based on the above problem recognition, and provides a technique advantageous in stabilizing a plasma potential in long-term use.

According to the present invention, there is provided a plasma processing apparatus, as defined in the claims.

According to one aspect of the present disclosure, there is provided a plasma processing apparatus comprising a balun including a first input terminal, a second input terminal, a first output terminal, and a second output terminal, a vacuum container, a first electrode insulated from the vacuum container and electrically connected to the first output terminal, and a second electrode insulated from the vacuum container and electrically connected to the second output terminal, wherein the second electrode is arranged to surround an entire circumference of the first electrode.

### BRIEF DESCRIPTION OF DRAWINGS

Fig. 1 is a circuit diagram schematically showing the arrangement of a plasma processing apparatus according to the first embodiment of the present invention;
Fig. 2A is a circuit diagram showing an example of the arrangement of a balun;
Fig. 2B is a circuit diagram showing another example of the arrangement of the balun; and
Fig. 3 is a circuit diagram schematically showing the arrangement of a plasma processing apparatus according to the second embodiment of the present invention.

### DESCRIPTION OF EMBODIMENTS

The present invention will be described below with reference to the accompanying drawings by way of exemplary embodiments.

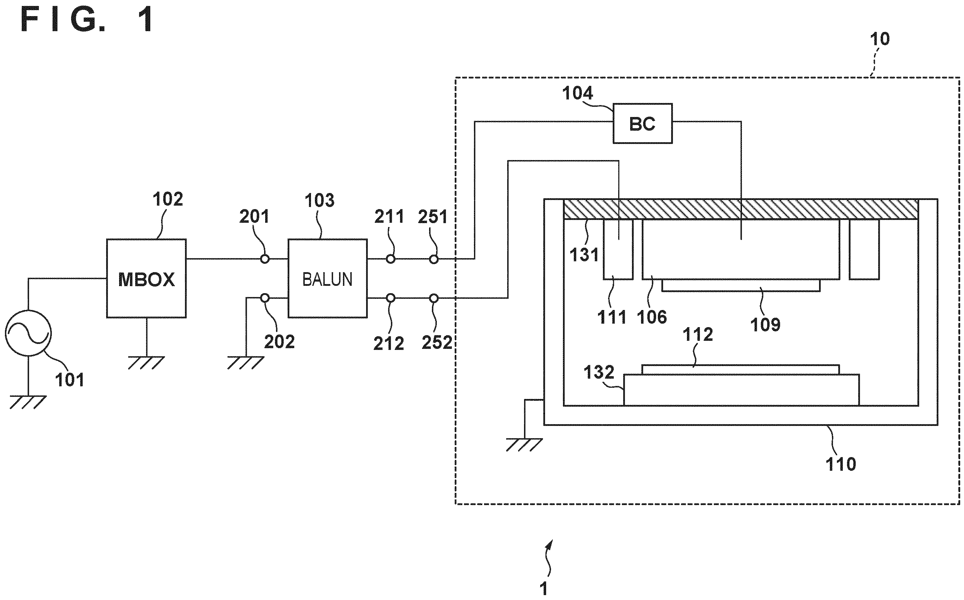

Fig. 1 schematically shows the arrangement of a plasma processing apparatus 1 according to the first embodiment of the present invention. The plasma processing apparatus 1 according to the first embodiment can operate as a sputtering apparatus that forms a film on a substrate 112 by sputtering. The plasma processing apparatus 1 includes a balun (balanced/unbalanced conversion circuit) 103, a vacuum container 110, a first electrode 106, a second electrode 111, and a substrate holding unit 132. Alternatively, it may be understood that the plasma processing apparatus 1 includes the balun 103 and a main body 10, and the main body 10 includes the vacuum container 110, the first electrode 106, the second electrode 111, and the substrate holding unit 132. The main body 10 includes a first terminal 251 and a second terminal 252. The first electrode 106 may be arranged to separate a vacuum space and an external space (that is, to form part of a vacuum partition) in cooperation with the vacuum container 110, or may be arranged in the vacuum container 110. The second electrode 111 may be arranged to separate a vacuum space and an external space (that is, to form part of a vacuum partition) in cooperation with the vacuum container 110, or may be arranged in the vacuum container 110.

The balun 103 includes a first input terminal 201, a second input terminal 202, a first output terminal 211, and a second output terminal 212. An unbalanced circuit is connected to the first input terminal 201 and the second input terminal 202 of the balun 103, and a balanced circuit is connected to the first output terminal 211 and the second output terminal 212 of the balun 103. At least a portion of the vacuum container 110 can be formed by a conductor. The vacuum container 110 can include a grounded portion. In one example, the conductor forming at least a portion of the vacuum container 110 can be grounded. However, in another example, the conductor forming at least a portion of the vacuum container 110 can electrically be connected to ground via an inductor. The first electrode 106 and the second electrode 111 are insulated from the vacuum container 110 (the conductor forming at least a portion of the vacuum container 110). In the example shown in Fig. 1, the first electrode 106 and the second electrode 111 are insulated from the vacuum container 110 (the conductor forming at least a portion of the vacuum container 110) by an insulator 131.

In the first embodiment, the first electrode 106 serves as a cathode, and holds a target 109. The target 109 can be, for example, an insulator material or a conductor material. Furthermore, in the first embodiment, the second electrode 111 serves as an anode. The first electrode 106 is electrically connected to the first output terminal 211, and the second electrode 111 is electrically connected to the second output terminal 212. When the first electrode 106 and the first output terminal 211 are electrically connected to each other, this indicates that a current path is formed between the first electrode 106 and the first output terminal 211 so that a current flows between the first electrode 106 and the first output terminal 211. Similarly, in this specification, when a and b are electrically connected, this indicates that a current path is formed between a and b so that a current flows between a and b.

The above arrangement can be understood as an arrangement in which the first electrode 106 is electrically connected to the first terminal 251, the second electrode 111 is electrically connected to the second terminal 252, the first terminal 251 is electrically connected to the first output terminal 211, and the second terminal 252 is electrically connected to the second output terminal 212.

The first electrode 106 and the second electrode 111 are arranged to oppose a space on the side of the substrate holding unit 132 (the substrate 112 held by the substrate holding unit 132). The second electrode 111 is arranged to surround the entire circumference of the first electrode 106. The second electrode 111 has a tubular shape. The first electrode 106 and the second electrode 111 have a coaxial structure. In one example, the first electrode 106 has a columnar shape centered on a virtual axis, and the second electrode 111 has a cylindrical shape centered on the virtual axis.

The above-described arrangement of the first electrode 106 and the second electrode 111 is advantageous in decreasing the impedance between the first electrode 106 and the second electrode 111. This is advantageous in decreasing a current flowing from the output side of the balun 103 to ground, that is, an in-phase current. Decreasing the in-phase current means that the vacuum container 110 is made hard to function as an anode. Although an unintended film can be formed on the inner wall of the vacuum container 110 along with formation of a film on the substrate 112, a plasma potential can be made insensitive to the state of the inner wall of the vacuum container 110 by making the vacuum container 110 hard to function as an anode. This is advantageous in stabilizing the plasma potential in long-term use of the plasma processing apparatus 1. From another viewpoint, the impedance between the first electrode 106 and the second electrode 111 is preferably lower than that between the first electrode 106 and the vacuum container 110. This is advantageous in decreasing the in-phase current.

The distance (the size of the gap) between the first electrode 106 and the second electrode 111 is preferably equal to or shorter than the Debye length.

This is effective for suppressing entering of plasma into the gap between the first electrode 106 and the second electrode 111.

A voltage appearing in the second electrode 111 can depend on the impedance between the second output terminal 212 and the second electrode 111. To cope with this, the electrical path length between the second output terminal 212 and the second electrode 111 is desirably shortened. Alternatively, an electrical path that connects the first output terminal 211 and the first electrode 106 and an electrical path that connects the second output terminal 212 and the second electrode 111 desirably have a coaxial structure.

According to the invention, the first electrode 106 and the first output terminal 211 (first terminal 251) are electrically connected via a blocking capacitor 104. The blocking capacitor 104 blocks a DC current flowing between the first output terminal 211 and the first electrode 106 (or between the first output terminal 211 and the second output terminal 212). According to an embodiment not being part of the invention, instead of providing the blocking capacitor 104, an impedance matching circuit 102 (to be described later) may be configured to block a DC current flowing between the first input terminal 201 and the second input terminal 202, or alternatively, the blocking capacitor 104 may be arranged in the electrical path between the second electrode 111 and the second output terminal 212.

The plasma processing apparatus 1 can further include a high-frequency power supply 101, and the impedance matching circuit 102 arranged between the high-frequency power supply 101 and the balun 103. The high-frequency power supply 101 supplies a high frequency (high-frequency current, high-frequency voltage, and high-frequency power) between the first input terminal 201 and the second input terminal 202 of the balun 103 via the impedance matching circuit 102. In other words, the high-frequency power supply 101 supplies a high frequency (high-frequency current, high-frequency voltage, and high-frequency power) between the first electrode 106 and the second electrode 111 via the impedance matching circuit 102, the balun 103, and the blocking capacitor 104. Alternatively, the high-frequency power supply 101 can be understood to supply a high frequency between the first terminal 251 and the second terminal 252 of the main body 10 via the impedance matching circuit 102 and the balun 103.

A gas (for example, Ar, Kr, or Xe gas) is supplied to the internal space of the vacuum container 110 through a gas supply unit (not shown) provided in the vacuum container 110. In addition, the high-frequency power supply 101 supplies a high frequency between the first electrode 106 and the second electrode 111 via the impedance matching circuit 102, the balun 103, and the blocking capacitor 104. This generates plasma, and generates a self-bias voltage on the surface of the target 109 to cause ions in the plasma to collide against the surface of the target 109, thereby discharging, from the target 109, the particles of a material constituting the target 109. Then, the particles form a film on the substrate 112.

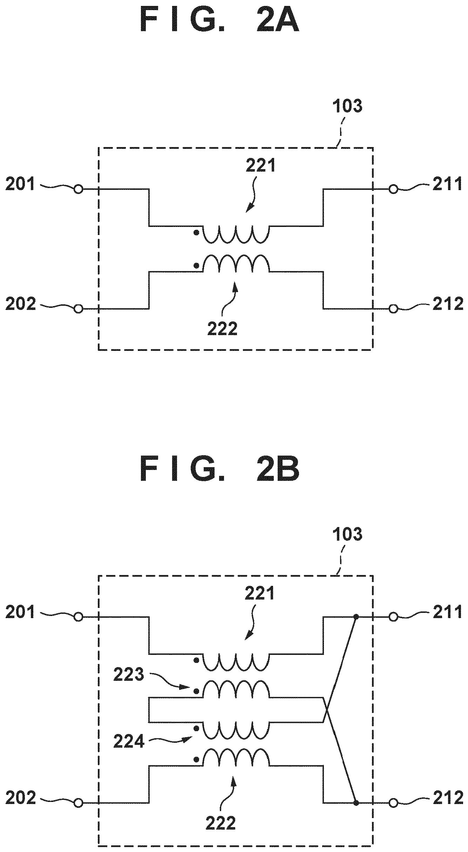

Fig. 2A shows an example of the arrangement of the balun 103. The balun 103 shown in Fig. 2A includes a first coil 221 that connects the first input terminal 201 and the first output terminal 211, and a second coil 222 that connects the second input terminal 202 and the second output terminal 212. The first coil 221 and the second coil 222 are coils having the same number of turns, and share an iron core.

Fig. 2B shows another example of the arrangement of the balun 103. The balun 103 shown in Fig. 2B includes a first coil 221 that connects the first input terminal 201 and the first output terminal 211, and a second coil 222 that connects the second input terminal 202 and the second output terminal 212. The balun 103 shown in Fig. 2B further includes a third coil 223 that is magnetically coupled to the first coil 221 by sharing an iron core with the first coil 221, and a fourth coil 224 that is magnetically coupled to the second coil 222 by sharing an iron core with the second coil 222. The first output terminal 211 and the second output terminal 212 are connected by a series circuit formed from the third coil 223 and the fourth coil 224. The first coil 221, the second coil 222, the third coil 223, and the fourth coil 224 are coils having the same number of turns, and share an iron core.

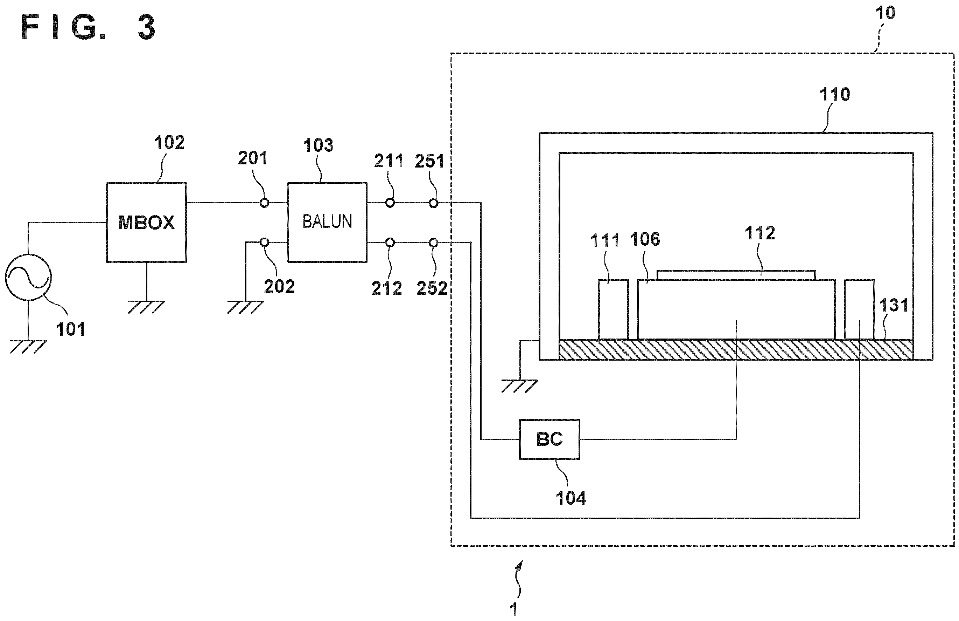

Fig. 3 schematically shows the arrangement of a plasma processing apparatus 1 according to the second embodiment of the present invention. Items which are not referred to as the second embodiment can comply with the first embodiment. The plasma processing apparatus 1 according to the second embodiment can operate as an etching apparatus that etches a substrate 112. In the second embodiment, a first electrode 106 serves as a cathode, and holds the substrate 112. In the second embodiment, a second electrode 111 serves as an anode. At least a portion of a vacuum container 110 can be formed by a conductor. The vacuum container 110 can include a grounded portion. In one example, the conductor forming at least a portion of the vacuum container 110 can be grounded. In another example, the conductor forming at least a portion of the vacuum container 110 can electrically be connected to ground via an inductor. The first electrode 106 and the second electrode 111 are insulated from the vacuum container 110 (the conductor forming at least a portion of the vacuum container 110). In the example shown in Fig. 3, the first electrode 106 and the second electrode 111 are insulated from the vacuum container 110 (the conductor forming at least a portion of the vacuum container 110) by an insulator 131.

In the plasma processing apparatus 1 according to the second embodiment, the first electrode 106 and a first output terminal 211 can electrically be connected via a blocking capacitor 104. In other words, in the plasma processing apparatus 1 according to the second embodiment, the blocking capacitor 104 is arranged in an electrical connection path between the first electrode 106 and the first input terminal 211. According to an embodiment not being part of the invention, instead of providing the blocking capacitor 104, an impedance matching circuit 102 may be configured to block a DC current flowing between a first input terminal 201 and a second input terminal or, alternatively, the blocking capacitor 104 may be arranged between the second electrode 111 and a second output terminal 212.

The present invention is not limited to the above-described embodiments, and various changes and modifications can be made within scope of the present invention. The invention is defined by the claims.

### REFERENCE SIGNS LIST

1: plasma processing apparatus, 10: main body, 101: high-frequency power supply, 102: impedance matching circuit, 103: balun, 104: blocking capacitor, 106: first electrode, 107, 108: insulator, 109: target, 110: vacuum container, 111: second electrode, 112: substrate, 132: substrate holding unit, 201: first input terminal, 202: second input terminal, 211: first output terminal, 212: second output terminal, 251: first terminal, 252: second terminal, 221: first coil, 222: second coil, 223: third coil, 224: fourth coil

## Claims

1. A plasma processing apparatus (1) comprising:
a balun (103) including a first input terminal (201) supplied with high frequency, a second input terminal (202) which is grounded, a first output terminal (211), and a second output terminal (212);
a vacuum container (110);
a first electrode (106) insulated from the vacuum container and electrically connected to the first output terminal; and
a second electrode (111) insulated from the vacuum container and electrically connected to the second output terminal;
the first output terminal (211) and the first electrode (106) are electrically connected to each other via a blocking capacitor (104),
**characterized in that**
the second electrode (111) has a tubular shape and is arranged to surround an entire circumference of the first electrode, the first electrode (106) and the second electrode (111) being arranged to form a coaxial structure, and
the second output terminal (212) and the second electrode (111) are electrically connected to each other not through a capacitor, the second electrode (111) being grounded via the balun (103).

2. The plasma processing apparatus (1) according to claim 1, wherein the first electrode (106) is configured to hold a member that is a substrate or a target, and an inner diameter of the second electrode (111) that has the tubular shape is larger than the member.

3. The plasma processing apparatus (1) according to claim 2, wherein the first electrode (106) has a columnar shape which has a surface configured to hold the member.

4. The plasma processing apparatus (1) according to any one of claims 1 to 3, wherein the vacuum container (110) includes a grounded portion.

5. The plasma processing apparatus (1) according to any one of claims 1 to 4, wherein the first electrode (106) serves as a cathode, and the second electrode (111) serves as an anode.

6. The plasma processing apparatus (1) according to any one of claims 1 to 5, wherein, in use, an impedance between the first electrode (106) and the second electrode (111) is lower than an impedance between the first electrode (106) and the vacuum container (110).

7. The plasma processing apparatus (1) according to claim 2 or 3, wherein, in use, a self-bias voltage is generated at the surface of the target.

8. The plasma processing apparatus (1) according to any one of claims 1 to 6, wherein the first electrode (106) holds a substrate (112), and the plasma processing apparatus (1) is configured as an etching apparatus which is configured to etch the substrate held by the first electrode.

9. The plasma processing apparatus (1) according to any one of claims 1 to 7, further comprising a substrate holding unit (132) configured to hold a substrate (112),
wherein the first electrode (106) holds a target (109),
wherein the first electrode (106) and the second electrode (111) are arranged to face a space on the side of the substrate holding unit (132), and
wherein the plasma processing apparatus (1) is configured as a sputtering apparatus which is configured to form a film on the substrate by sputtering of the target.

10. The plasma processing apparatus (1) according to any one of claims 1 to 9, further comprising:
a high-frequency power supply (101); and
an impedance matching circuit (102) arranged between the high-frequency power supply (101) and the balun (103).

## Patentansprüche

1. Plasmaverarbeitungsvorrichtung (1) mit:
einem Balun (103) mit einem ersten Eingangsanschluss (201), der mit Hochfrequenz versorgt wird, einem zweiten Eingangsanschluss (202), der geerdet ist, einem ersten Ausgangsanschluss (211) und einem zweiten Ausgangsanschluss (212);
einem Vakuumbehälter (110);
einer ersten Elektrode (106), die von dem Vakuumbehälter isoliert ist und mit dem ersten Ausgangsanschluss elektrisch verbunden ist; und
einer zweiten Elektrode (111), die von dem Vakuumbehälter isoliert ist und mit dem zweiten Ausgangsanschluss elektrisch verbunden ist;
wobei der erste Ausgangsanschluss (211) und die erste Elektrode (106) über einen Trennkondensator (104) elektrisch miteinander verbunden sind,
**dadurch gekennzeichnet, dass**
die zweite Elektrode (111) eine röhrenartige Form aufweist und so angeordnet ist, dass sie einen gesamten Umfang der ersten Elektrode umgibt, wobei die erste Elektrode (106) und die zweite Elektrode (111) so angeordnet sind, dass sie eine koaxiale Struktur bilden, und
der zweite Ausgangsanschluss (212) und die zweite Elektrode (111) nicht über einen Kondensator elektrisch miteinander verbunden sind, wobei die zweite Elektrode (111) über den Balun (103) geerdet ist.

2. Plasmaverarbeitungsvorrichtung (1) gemäß Anspruch 1, wobei die erste Elektrode (106) konfiguriert ist zum Halten eines Elements, das ein Substrat oder ein Zielobjekt ist, und ein Innendurchmesser der zweiten Elektrode 111, die die röhrenartige Form aufweist, größer ist als das Element.

3. Plasmaverarbeitungsvorrichtung (1) gemäß Anspruch 2, wobei die erste Elektrode (106) eine säulenartige Form aufweist, die eine Oberfläche aufweist, die zum Halten des Elements konfiguriert ist.

4. Plasmaverarbeitungsvorrichtung (1) gemäß einem der Ansprüche 1 bis 3, wobei der Vakuumbehälter (110) einen geerdeten Teil umfasst.

5. Plasmaverarbeitungsvorrichtung (1) gemäß einem der Ansprüche 1 bis 4, wobei die erste Elektrode (106) als eine Katode dient und die zweite Elektrode (111) als eine Anode dient.

6. Plasmaverarbeitungsvorrichtung (1) gemäß einem der Ansprüche 1 bis 5, wobei, in Verwendung, eine Impedanz zwischen der ersten Elektrode (106) und der zweiten Elektrode (111) niedriger ist als eine Impedanz zwischen der ersten Elektrode (106) und dem Vakuumbehälter (110).

7. Plasmaverarbeitungsvorrichtung (1) gemäß Anspruch 2 oder 3, wobei, in Verwendung, eine Eigenvorspannung an der Oberfläche des Zielobjekts erzeugt wird.

8. Plasmaverarbeitungsvorrichtung (1) gemäß einem der Ansprüche 1 bis 6, wobei die erste Elektrode (106) ein Substrat (112) hält, und die Plasmaverarbeitungsvorrichtung (1) als eine Ätzvorrichtung konfiguriert ist, die konfiguriert ist zum Ätzen des durch die erste Elektrode gehaltenen Substrats.

9. Plasmaverarbeitungsvorrichtung (1) gemäß einem der Ansprüche 1 bis 7, zusätzlich mit einer Substrathalteeinheit (132), die konfiguriert ist zum Halten eines Substrats (112),
wobei die erste Elektrode (106) ein Zielobjekt (109) hält,
wobei die erste Elektrode (106) und die zweite Elektrode (111) so angeordnet sind, dass sie einem Raum auf der Seite der Substrathalteeinheit (132) zugewandt sind, und
wobei die Plasmaverarbeitungsvorrichtung (1) als eine Sputtervorrichtung konfiguriert ist, die konfiguriert ist zum Ausbilden einer Schicht auf dem Substrat durch Zerstäuben des Zielobjekts.

10. Plasmaverarbeitungsvorrichtung (1) gemäß einem der Ansprüche 1 bis 9, zusätzlich mit:
einer Hochfrequenzleistungsversorgung (101); und
einer Impedanzanpassungsschaltung (102), die zwischen der Hochfrequenzleistungsversorgung (101) und dem Balun (103) angeordnet ist.

## Revendications

1. Appareil de traitement au plasma (1) comprenant :
un symétriseur (103) comportant une première borne d'entrée (201) alimentée avec une haute fréquence, une seconde borne d'entrée (202) qui est mise à la masse, une première borne de sortie (211), et une seconde borne de sortie (212) ;
une enceinte sous vide (110) ;
une première électrode (106) isolée de l'enceinte sous vide et électriquement connectée à la première borne de sortie ; et
une seconde électrode (111) isolée de l'enceinte sous vide et électriquement connectée à la seconde borne de sortie ;
la première borne de sortie (211) et la première électrode (106) sont électriquement connectées l'une à l'autre via un condensateur de blocage (104),
**caractérisé en ce que**
la seconde électrode (111) possède une géométrie tubulaire et est agencée pour encercler la totalité d'une circonférence de la première électrode, la première électrode (106) et la seconde électrode (111) étant agencées pour former une structure coaxiale, et
la seconde borne de sortie (212) et la seconde électrode (111) sont électriquement connectées l'une à l'autre, pas par le biais d'un condensateur, la seconde électrode (111) étant mise à la masse via le symétriseur (103).

2. Appareil de traitement au plasma (1) selon la revendication 1, dans lequel la première électrode (106) est configurée pour tenir une pièce qui est un substrat ou une cible, et un diamètre interne de la seconde électrode (111) qui possède la géométrie tubulaire est plus grand que la pièce.

3. Appareil de traitement au plasma (1) selon la revendication 2, dans lequel la première électrode (106) possède une géométrie colonnaire qui possède une surface configurée pour tenir la pièce.

4. Appareil de traitement au plasma (1) selon l'une quelconque des revendications 1 à 3, dans lequel l'enceinte sous vide (110) comporte une partie mise à la masse.

5. Appareil de traitement au plasma (1) selon l'une quelconque des revendications 1 à 4, dans lequel la première électrode (106) sert de cathode, et la seconde électrode (111) sert d'anode.

6. Appareil de traitement au plasma (1) selon l'une quelconque des revendications 1 à 5, dans lequel, en utilisation, une impédance entre la première électrode (106) et la seconde électrode (111) est inférieure à une impédance entre la première électrode (106) et l'enceinte sous vide (110).

7. Appareil de traitement au plasma (1) selon la revendication 2 ou 3, dans lequel, en utilisation, une tension d'auto-polarisation est générée à la surface de la cible.

8. Appareil de traitement au plasma (1) selon l'une quelconque des revendications 1 à 6, dans lequel la première électrode (106) tient un substrat (112), et l'appareil de traitement au plasma (1) est configuré comme un appareil de gravure qui est configuré pour graver le substrat tenu par la première électrode.

9. Appareil de traitement au plasma (1) selon l'une quelconque des revendications 1 à 7, comprenant en outre une unité de tenue de substrat (132) configurée pour tenir un substrat (112),
dans lequel la première électrode (106) tient une cible (109) ,
dans lequel la première électrode (106) et la seconde électrode (111) sont agencées pour faire face à un espace sur le côté de l'unité de tenue de substrat (132), et
dans lequel l'appareil de traitement au plasma (1) est configuré comme un appareil de pulvérisation cathodique qui est configuré pour former un film sur le substrat par pulvérisation cathodique de la cible.

10. Appareil de traitement au plasma (1) selon l'une quelconque des revendications 1 à 9, comprenant en outre :
une alimentation électrique à haute fréquence (101) ; et
un circuit d'adaptation d'impédance (102) agencé entre l'alimentation électrique à haute fréquence (101) et le symétriseur (103).
